# FASCICULE DE BREVET EUROPEEN

(11) **EP 4 385 734 B1**
(45) Date de publication et mention de la délivrance du brevet: **18.06.2025**
(21) Numéro de dépôt: 23212776.1
(22) Date de dépôt: 28.11.2023
(51) Int. Cl.: B32B 43/00, B26F 1/08, B26D 1/15, B26D 3/08, H10F 19/80, B23K 26/402

(54) **PROCÉDÉ DE DÉLAMINATION D'UN DISPOSITIF MULTICOUCHE**
VERFAHREN ZUR DELAMINIERUNG EINER MEHRSCHICHTIGEN VORRICHTUNG
METHOD FOR DELAMINATING A MULTILAYER DEVICE

(30) Priorité: 12.12.2022 FR 2213150
(43) Date de publication de la demande: 19.06.2024
(73) Titulaire: Commissariat à l'Energie Atomique et aux Energies Alternatives, 75015 Paris (FR)
(72) Inventeur: RUIZ, Jean-Christophe, 30290 LAUDUN L ARDOISE (FR); BRIAND, Axel, 84130 LE PONTET (FR); LIOTAUD, Lucas, 84000 AVIGNON (FR)
(74) Mandataire: Hautier IP

(56) Documents cités:
- CN-A- 115 090 645
- FR-A1- 3 088 579

## Description

### DOMAINE TECHNIQUE

La présente invention concerne un procédé de délamination d'un dispositif multicouche. Plus particulièrement, l'invention concerne un procédé de délamination d'un dispositif multicouche comprenant plusieurs couches, au moins l'une de ces couches étant une structure organique, en vue notamment du recyclage des matériaux constituant ces couches.

Le procédé selon l'invention s'applique à la délamination de tout dispositif multicouche, quel qu'il soit. De tels dispositifs multicouches se rencontrent par exemple dans les emballages alimentaires, les emballages pharmaceutiques, les dispositifs électroniques tels que les écrans d'ordinateurs, les téléphones portables, les téléviseurs, les dispositifs à diodes électroluminescentes notamment à diodes électroluminescentes organiques, etc. En particulier, le procédé selon l'invention s'applique à la délamination de dispositifs multicouches faisant partie de panneaux photovoltaïques, quelle que soit la technologie envisagée, en vue du recyclage des matériaux les constituant.

### ETAT DE LA TECHNIQUE

Il existe diverses technologies de panneaux photovoltaïques (panneaux PV) ; cependant les panneaux voltaïques qui mettent en oeuvre une technologie au silicium - que le silicium soit cristallin, c'est à dire monocristallin ou polycristallin, ou encore amorphe - sont actuellement les plus courants. Il est à noter que l'on utilise souvent indifféremment les termes panneau photovoltaïque (panneau PV) et module photovoltaïque (module PV). Cependant, de manière plus précise, on considérera dans la présente, qu'un panneau photovoltaïque (panneau PV) comprend généralement un module photovoltaïque (module PV) ou laminé photovoltaïque (laminé PV), éventuellement un cadre - le plus souvent en aluminium - qui entoure le module PV, et une boîte de jonction. Il existe des panneaux sans cadre, auquel cas le terme panneau photovoltaïque désigne simplement le module PV ou laminé PV avec la boîte de jonction, et on peut dans ce cas effectivement utiliser indifféremment les termes panneau PV et module PV.

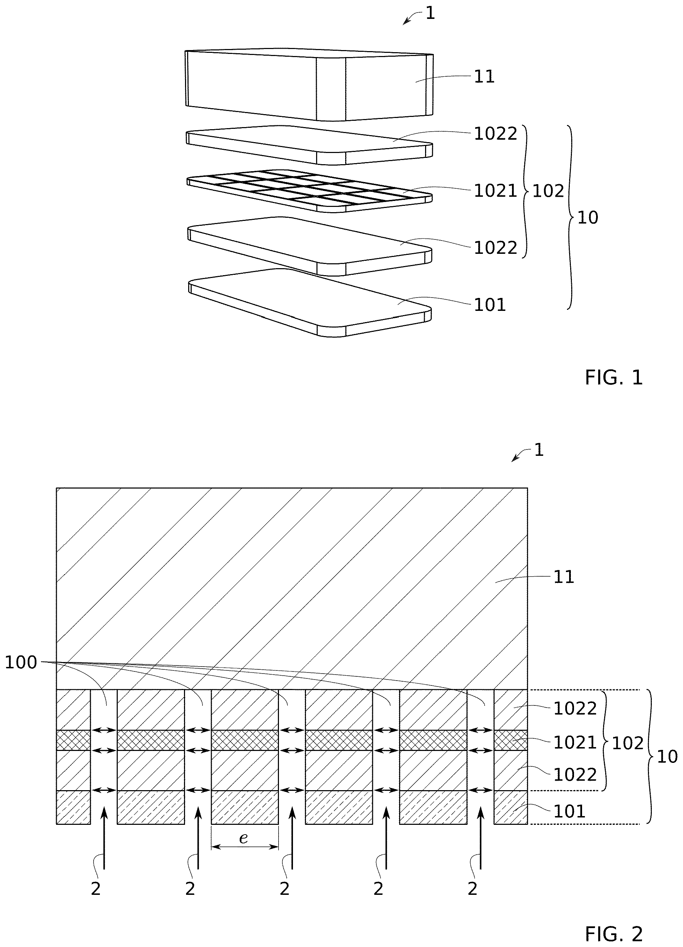

A titre d'exemple, la figure 1 représente la structure d'un panneau PV qui peut également être éventuellement appelé module PV, mettant en oeuvre une technologie au silicium, notamment au silicium cristallin. Un tel module PV 1 est un assemblage multicouche de polymères permettant d'assurer la connexion électrique des cellules, ainsi que leur protection tout au long de la vie du panneau. Le verre 11, en face avant, permet la protection face aux intempéries et doit assurer une bonne transmission optique (>90 %). La face arrière 101 (ou « backsheet » selon la terminologie anglo-saxonne) comprend un assemblage multicouche de polymères. Il est généralement constitué d'une couche de poly(éthylène téréphtalate) (ou PET) en adhérence entre deux couches de polymère fluoré tel que le poly(fluorure de vinyle) (ou PVF) ou poly(fluorure de vinylidène) (ou PVDF). Les polymères fluorés présentent des propriétés d'imperméabilité et permettent d'éviter la pénétration d'eau au sein du module PV. La face avant 11 en verre, la face arrière 101, ainsi que les cellules photovoltaïques 1021 connectées électriquement, sont assemblées grâce à une ou plusieurs couches d'encapsulant 1022 qui permet d'assurer l'adhérence de l'ensemble des constituants. L'encapsulant principalement utilisé est le poly(éthylène-co-acétate de vinyle) (ou EVA).

Un procédé complet de recyclage des panneaux PV met généralement en œuvre la succession d'étapes suivante :
a. Le démantèlement du panneau PV consistant à séparer la boite de jonction et le cadre en aluminium du module PV,
b. La délamination du module PV, puis
c. La récupération des métaux contenus dans la cellule.

Les procédés de délamination peuvent être mécaniques, thermiques ou chimiques ou un couplage de ces procédés.

Pour mettre en œuvre ces procédés, un pré-traitement mécanique est généralement réalisé pour réduire le temps de traitement liée à l'étape de délamination où la cinétique est généralement limitante, en particulier pour les traitements thermiques ou chimiques. Ces pré-traitements peuvent être un broyage (Cf. G. Granata, F. Pagnanelli, E. Moscardini, T. Havlik, L. Toro, Recycling of photovoltaic panels by physical operations, Solar Energy Materials and Solar Cells. 123 (2014) 239-248), un concassage ou encore une découpe du module PV (Cf. V. Savvilotidou, E. Gidarakos, Pre-concentration and recovery of silver and indium from crystalline silicon and copper indium selenide photovoltaic panels, Journal of Cleaner Production. 250 (2020) et A. Kuczyńska- 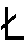 azewska, E. Klugmann-Radziemska, Influence of fragment size on the time and temperature of ethylene vinyl acetate lamination decomposition in the photovoltaic module recycling process, Materials. 12 (2019)). Ces techniques visent toutes la réduction de taille de la structure multicouche à traiter.

Ces procédés de pré-traitement par réduction de taille dégradent les matériaux constitutifs du module PV et limitent leur recyclage à forte valeur ajoutée. Par ailleurs, ils génèrent une perte de matière valorisable due à une faible sélectivité de ces techniques. De plus, ces pré-traitements mécaniques contaminent les matériaux de la cellule généralement introduits par un mélange de matière du module PV. Par exemple, des fragments de verre ont tendance à se retrouver dans le même flux que celui des fragments de cellule. Ces deux matériaux étant principalement composés de silicium, la récupération du silicium de la cellule avec un haut-degré de pureté est difficile, voire impossible, sans mettre en jeu des moyens de séparation complexe et couteux. Enfin, ces procédés nécessitent une consommation énergétique importante pour réduire le panneau d'une taille de l'ordre du m² à des fragments de l'ordre de quelques mm².

Les techniques de pré-traitement mécanique ne sont donc à ce jour pas satisfaisantes pour répondre aux objectifs de recyclage à forte valeur ajoutée avec une perte de matière limitée.

Le procédé de délamination décrit dans le brevet FR3088579 (A1) consiste à utiliser un fluide, par exemple le CO2, dans son état supercritique, qui est un état intermédiaire entre les phases liquides et gazeuses du fluide. Le fluide, et notamment le CO2, dans son état supercritique présente notamment une capacité à diffuser très facilement au coeur des matériaux poreux (diffusion à l'échelle moléculaire) et d'induire une expansion par moussage des couches polymériques lorsqu'il est retiré brutalement.

Le procédé utilisé dans le brevet FR3088579 (A1) comprend plus particulièrement la réalisation de cycles de pressurisation et de dépressurisation. Ces cycles provoquent successivement une insertion du fluide au coeur de la matrice du matériau traité puis une désorption du fluide ; cette dernière s'accompagnant d'une augmentation du volume molaire du fluide et, par voie de conséquence, d'une expansion des matériaux saturés de fluide. Chaque cycle est conduit de manière brutale et instantanée que ce soit pour la pressurisation ou pour la dépressurisation. Les expansions et pertes d'expansion successives induisent une déformation mécanique des polymères plus poussée qu'un simple trempage en CO2 seul, ou en CO2 et co-solvant, et pour des durées plus courtes avec un impact énergétique et économique plus favorable.

En effet, l'incorporation forcée et très rapide de fluide supercritique (ou SC) dans la matrice des polymères, suivie d'un retrait tout aussi rapide du fluide depuis les feuillets de polymères forment un tout de nature à exacerber les tensions mécaniques entre la structure rigide, à base de silicium, et la structure souple, à base de polymères, du module PV, du fait de la brutalité des conditions appliquées.

Toutefois, la diffusion du fluide SC dans les polymères constituants un module PV peut être limitante dans le cas de la délamination d'un module PV de grandes tailles. À titre de comparaison, la surface traitable pour un temps de traitement d'une heure avec la délamination par CO2 supercritique (ou CO2 SC) pulsé est de 8×8 mm², contre 10×10 mm² pour le traitement thermique (Cf. A. Kuczyńska- 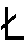 azewska, E. Klugmann-Radziemska, Influence of fragment size on the time and temperature of ethylene vinyl acetate lamination decomposition in the photovoltaic module recycling process, Materials. 12 (2019)) et de l'ordre du mm² pour la délamination chimique (Cf. F. Pagnanelli, E. Moscardini, P. Altimari, F.C.S.M. Padoan, T. Abo Atia, F. Beolchini, A. Amato, L. Toro, Solvent versus thermal treatment for glass recovery from end of life photovoltaic panels: Environmental and economic assessment, Journal of Environmental Management. 248 (2019)). Dans le cas de la mise en œuvre du procédé de délamination par CO2 SC pulsé, le coefficient de diffusion du CO2 SC dans l'EVA est compris entre 0,5 et 2,0 ×10⁻⁹ m².s⁻¹ (Cf. A. Briand, A. Leybros, C. Audoin, J.C. Ruiz, F. Lamadie, A. Grandjean, CO2 absorption into a polymer within a multilayer structure: The case of poly(ethylene-co-vinyl acetate) in photovoltaic modules, The Journal of Supercritical Fluids. 179 (2022) 105380). Malgré le fait que cette valeur se situe dans la gamme haute des coefficients de diffusion du CO2 SC dans les polymères solides (10⁻¹² - 10⁻⁸ m².s⁻¹), l'utilisation du CO2 SC ne permet pas une pénétration du CO2 suffisante pour le traitement de modules PV de grandes tailles (> 1 m²), à tout le moins dans des délais compatibles avec un procédé industriel.

Il est donc souhaitable de proposer un procédé de délamination d'un dispositif multicouche comprenant au moins une structure organique qui soit une solution technique robuste permettant d'accélérer la cinétique de traitement.

Il est encore souhaitable de proposer un tel procédé qui permette en outre de ne pas avoir à réduire la taille du module PV et à éviter ainsi les dégradations et contaminations générées par les procédés de réduction de taille du module PV en fragments de l'ordre de quelques mm².

### RESUME

Pour atteindre cet objectif, selon un mode de réalisation, on prévoit un procédé de délamination d'un dispositif multicouche comprenant au moins une structure organique, le procédé comprenant les étapes suivantes :
a. Une étape de pré-traitement du dispositif multicouche consistant à perforer ladite au moins une structure organique par endroits, puis
b. Une étape de traitement, dans un réacteur, du dispositif multicouche consistant à le soumettre à au moins un cycle de pressurisation et de dépressurisation d'un fluide.

L'étape de pré-traitement permet ainsi de créer, dans la structure organique, des chemins de pénétration pour le fluide.

Ainsi, grâce à l'étape de pré-traitement, la pénétration des molécules du fluide dans la structure organique est favorisée lors de l'étape de traitement. Cela permet de réduire significativement le temps nécessaire à la réalisation de l'étape de traitement, et en particulier le temps nécessaire à l'obtention d'un dispositif multicouche entièrement délaminé, y compris et surtout lorsque le dispositif multicouche n'a pas été réduit en fragments.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La figure 1 représente une vue éclatée d'un exemple de dispositif multicouche sur lequel il est avantageusement prévu de mettre en œuvre le procédé selon l'invention.
La figure 2 représente une vue en coupe dans le dispositif multicouche de la figure 1 au niveau d'une pluralité de perforation de la structure organique du dispositif multicouche.
Les figures 3A à 3C représentent des résultats d'essais effectués sur des panneaux PV perforés avec 2 cycles de pressurisation et de dépressurisation et différents espacements entre perforations : un espacement de 10 mm pour la figure 3A, un espacement de 7,5 mm pour la figure 3B est un espacement de 5 mm pour la figure 3C.
La figure 4 illustre un schéma d'un premier exemple de dispositif mécanique propre à permettre la mise en œuvre de l'étape de prétraitement du dispositif multicouche selon le procédé de l'invention.
Les figures 5A à 5B représentent schématiquement d'autres exemples de dispositif mécanique propre à permettre la mise en œuvre de l'étape de prétraitement du dispositif multicouche selon le procédé de l'invention, ainsi que le dispositif multicouche en cours de prétraitement.
La figure 6 représente schématiquement un exemple de dispositif laser propre à permettre la mise en œuvre de l'étape de prétraitement du dispositif multicouche selon le procédé de l'invention, ainsi que le dispositif multicouche en cours de prétraitement.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs des différentes couches de chaque dispositif multicouche représenté ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, le dispositif multicouche comprenant en outre une face avant en verre, la perforation de ladite au moins une structure organique est réalisée depuis une face arrière du dispositif multicouche qui est opposée à sa face avant.

Selon un exemple, ladite au moins une structure organique comprend une face arrière à base d'au moins un polymère et une couche comprenant au moins un transducteur et le cas échéant un encapsulant dudit au moins un transducteur, l'encapsulant étant à base d'au moins un polymère.

Selon un exemple, dans le dispositif multicouche, la face avant du dispositif multicouche est opposée à la face arrière de ladite au moins une structure organique.

Selon un exemple, au moins une perforation, de préférence chaque perforation, est réalisée dans une épaisseur de ladite au moins une structure organique du dispositif multicouche. De préférence, au moins une perforation, de préférence chaque perforation est réalisée dans toute l'épaisseur de ladite au moins une structure organique du dispositif multicouche.

Selon un exemple, au moins une perforation, de préférence chaque perforation, de ladite au moins une structure organique se présente sous la forme d'un trou ou d'une strie.

Selon un exemple, chaque perforation se situe à une distance maximale inférieure ou égale à 10 mm, préférentiellement inférieure ou égale à 7,5 mm, et encore plus préférentiellement inférieure ou égale à 5 mm, d'une autre perforation.

Selon un exemple, l'étape de traitement a une durée inférieure à 120 minutes, préférentiellement inférieure à 60 minutes et encore plus préférentiellement inférieure à 45 minutes.

Selon un exemple, le fluide est choisi parmi :
a. le dioxyde de carbone CO2 ;
b. l'hexafluorure de soufre ;
c. le protoxyde d'azote ;
d. les alcanes linéaires ou ramifiés, tels que le méthane, les propanes, les butanes, et les pentanes ;
e. les alcanes cycliques ;
f. les alcènes linéaires ou ramifiés, tels que l'éthylène et le propylène ;
g. les alcools, tels que le méthanol, l'éthanol, les propanols, et les butanols ; et
h. leurs mélanges.

Plus particulièrement, le fluide peut être choisi parmi le dioxyde de carbone CO2 ; l'hexafluorure de soufre ; le protoxyde d'azote ; les alcanes linéaires ou ramifiés, de préférence les alcanes linéaires ou ramifiés de 1 à 10 atomes de carbone, notamment de 1 à 5 atomes de carbone, tels que le méthane, les propanes, les butanes, et les pentanes ; les alcanes cycliques, de préférence les alcanes cycliques de 3 à 10 atomes de carbone ; les alcènes linéaires ou ramifiés, de préférence les alcènes linéaires ou ramifiés de 2 à 10 atomes de carbone, notamment de 2 à 5 atomes de carbone, tels que l'éthylène et le propylène ; les alcools, de préférence les alcools aliphatiques de 1 à 5 atomes de carbone comme le méthanol, l'éthanol, les propanols, et les butanols ; et leurs mélanges ; notamment, le fluide peut être choisi parmi les mélanges de dioxyde de carbone CO2 et d'au moins un autre fluide choisi parmi les fluides énumérés précédemment.

Selon un exemple, chaque cycle de pressurisation et de dépressurisation comprend :
a. une compression du fluide en augmentant la pression dans le réacteur jusqu'à une pression P1, à laquelle le fluide se trouve dans un premier état physique; puis
b. une décompression du fluide en diminuant la pression dans le réacteur depuis la pression P1 jusqu'à une pression P2 à laquelle le fluide se trouve dans un deuxième état physique, la pression P2 étant inférieure à la pression P1.

Selon un exemple, ledit au moins un cycle est précédé d'une mise en contact, dans le réacteur, du dispositif multicouche avec le fluide à une température T0, telle que la température ambiante, et une pression P0, telle que la pression atmosphérique.

Selon un exemple, le procédé de délamination selon invention est exempt d'une étape de réduction de taille du dispositif multicouche, et en particulier exempt d'une étape de broyage ou de concassage du dispositif multicouche.

Selon un exemple, au moins une perforation est réalisée à l'aide d'un laser.

Selon un exemple, une pluralité de perforations est réalisée simultanément à l'aide d'une pluralité correspondante de pointes s'étendant depuis une même face d'une plaque.

Selon un exemple, une pluralité de perforations est réalisée à l'aide d'un rouleau strié ou à pointes.

Comme annoncé en introduction, la présente invention vise à proposer un procédé de délamination d'un dispositif multicouche comprenant au moins une structure organique qui soit une solution technique robuste permettant d'accélérer la cinétique de traitement. Elle vise encore à proposer un tel procédé qui permette en outre de ne pas avoir à réduire la taille du module PV et à éviter ainsi les dégradations et contaminations générées par les procédés de réduction de taille du module PV en fragments de l'ordre de quelques millimètres carrés.

Pour atteindre ces objectifs, une première solution immédiatement envisageable consisterait à découper un dispositif multicouche de grande taille en plusieurs morceaux de quelques centimètres carrés de côté. La cinétique de traitement s'en trouverait effectivement augmentée, du fait que la surface de contact entre la structure organique et le fluide s'en trouverait accrue. Cependant, l'intégrité de l'éventuelle face avant en verre du dispositif multicouche ne serait pas conservée, rendant impossible sa réutilisation. Cette première solution est encore critiquable en ce que :
a. les découpes qu'elle met en œuvre peuvent conduire à une dégradation et/ou à une contamination des différentes couches du dispositif multicouche entre elles, et/ou
b. les découpes qu'elle met en œuvre engendrent une perte de matière qu'il serait bon de réduire, voire d'éviter.

La présente invention propose d'atteindre les objectifs visés de façon différente de la première solution envisagée ci-dessus, et plus particulièrement d'une façon qui permet de préserver l'intégrité de l'éventuelle face avant en verre du dispositif multicouche, de sorte à permettre sa réutilisation.

Plus particulièrement, et en référence à la figure 2, la présente invention concerne un procédé de délamination d'un dispositif multicouche 1 comprenant au moins une structure organique 10, qui comprend les étapes suivantes :
a. Une étape de pré-traitement du dispositif multicouche 1 consistant à perforer 100 ladite au moins une structure organique 10 par endroits, puis,
b. Une étape de traitement, dans un réacteur, du dispositif multicouche 1 consistant à le soumettre à au moins un cycle de pressurisation et de dépressurisation d'un fluide 2.

L'étape de pré-traitement permet ainsi de créer, dans la structure organique 10, des chemins de pénétration pour le fluide 2.

Ainsi, grâce à l'étape de pré-traitement, la pénétration des molécules du fluide 2 dans la structure organique 10 est favorisée lors de l'étape de traitement. Cela permet de réduire significativement le temps nécessaire à la réalisation de l'étape de traitement, et en particulier le temps nécessaire à l'obtention d'un dispositif multicouche 1 entièrement délaminé, y compris et surtout lorsque l'intégrité d'une éventuelle face avant 11 en verre du dispositif multicouche 1 est à maintenir pour permettre la réutilisation de ladite face avant 11. Cette réutilisation est d'autant plus souhaitable que la face avant 11 en verre d'un panneau PV 1 représente plus de 75% du poids du panneau, et que le verre est spécial.

Dès lors, l'on comprend que le procédé selon l'invention est de préférence exempt d'une étape de réduction de taille du dispositif multicouche 1, et en particulier exempt d'une étape de broyage ou de concassage du dispositif multicouche 1, notamment de nature à réduire le dispositif multicouche en fragments de l'ordre de quelques millimètres carrés.

Le procédé de délamination selon la présente invention permet ainsi de conserver l'intégrité du dispositif multicouche 1 en vue de son traitement, notamment selon la solution de délamination divulguée dans le document de brevet référencé FR3088579 A1.

Si le procédé selon l'invention se distingue des procédés de l'état de l'art, tels que le broyage ou le concassage, ou même la solution introduite ci-dessus, qui dégradent la structure, contaminent les matériaux en vue de leur recyclage et induisent une perte de matière, le pré-traitement selon le procédé de l'invention peut avoir en outre un avantage énergétique comparé aux procédés mécaniques conventionnels de réduction de taille qui sont relativement énergivores. En outre ce pré-traitement, qui, comme nous le verrons plus bas, peut être automatisé, est adapté aux moyens mis en œuvre généralement au niveau industriel.

Le procédé selon l'invention trouve à s'appliquer de façon particulièrement avantageuse, mais de façon non limitative, à un panneau PV, ou plus particulièrement à un module PV, tel qu'illustré sur la figure 1. Plus particulièrement, le module PV illustré sur la figure 1 présente, en tant que dispositif multicouche 1, au moins une structure dite organique 10, car principalement composée de matière polymérique, et une face avant 11 en verre. Dans cet exemple, la structure organique 10 comprend donc une face arrière 101 à base d'au moins un polymère et une couche 102 comprenant au moins un transducteur 1021, tel qu'une cellule PV, et un encapsulant 1022 dudit au moins un transducteur 1021, l'encapsulant étant à base d'au moins un polymère. Ces considérations permettent de faire le lien entre la description détaillée donnée en introduction de la demande du module PV illustré sur la figure 1 et les différents vocables utilisés pour décrire la présente invention. L'on comprend ainsi que la structure organique revendiquée peut éventuellement comprendre une cellule, et plus particulièrement une pluralité de cellules PV, encapsuler dans un polymère et/ou agencés dans un dispositif multicouche comprenant, en plus des cellules PV, des couches en matériau(x) organique(s). Il va de soi que le procédé selon l'invention n'est pas uniquement applicable au type de modules PV décrits en introduction de la présente demande, mais est applicable à tout autre type de modules PV.

Si l'exemple d'une application à la délamination d'un module PV est utilisé ci-dessous pour décrire plus avant la présente invention, rappelons ici que cette dernière est applicable à d'autres dispositifs multicouches, tels que les emballages alimentaires, les emballages pharmaceutiques, les dispositifs électroniques tels que les écrans d'ordinateurs, les téléphones portables, les téléviseurs, les dispositifs à diodes électroluminescentes notamment à diodes électroluminescentes organiques, etc. Notons encore que certains de ces dispositifs multicouches comprennent des transducteurs différents de ceux que constituent les cellules photovoltaïques, et que certains autres de ces dispositifs multicouches ne comprennent pas de transducteur.

Sur la figure 2, est reproduite la structure du dispositif multicouche illustré sur la figure 1.

On observe sur la figure 2 que chaque perforation 100 de la structure organique 10 est réalisée depuis la face arrière 101 du dispositif multicouche 1. On observe encore que chaque perforation 100 est réalisée dans l'épaisseur de la structure organique 10. Plus particulièrement, chaque perforation est réalisée perpendiculairement à un plan d'extension principale de la structure organique 10. Il va de soi que le procédé selon l'invention n'est pas limité à une telle orthogonalité, les perforations 100 pouvant aussi bien être inclinées relativement à la perpendiculaire au plan d'extension principale de la structure organique 10. Par ailleurs, notons que les perforations 100 passent, dans l'exemple illustré sur la figure 2, à travers la couche de cellules PV 1021.

De préférence, et comme illustré sur la figure 2, chaque perforation est réalisée dans toute l'épaisseur de la structure organique 10. De la sorte, la diffusion du fluide 2 lors du traitement du dispositif multicouche 1 dans le réacteur est favorisée dans toute l'épaisseur de la structure organique 10, et plus particulièrement au niveau de chacune des sous-couches de la structure organique 10.

La profondeur des perforations 100 est donc un paramètre important du procédé selon la présente invention. Et les perforations 100 sont de préférence dimensionnées de sorte que le fluide 2 diffuse de manière efficace à travers la structure organique 10, qui, pour l'exemple illustré sur la figure 2, est composée, successivement par ordre de sous-couche perforée, de bas en haut, de la face arrière 101 (qui est elle-même une multicouche PVF/PET/PVF), de l'encapsulant 1022 à base d'EVA, de la couche de cellules photovoltaïques 1021, et d'une autre couche de l'encapsulant 1022 à base d'EVA. Par exemple, pour un module PV 1 de 5 mm d'épaisseur constitué d'une face avant 11 en verre d'une épaisseur de 3 mm, une perforation d'une profondeur de 2 mm permet la diffusion du fluide 2 dans la totalité de la structure organique 10.

Nous verrons plus bas, lorsque nous détaillerons différents dispositifs de perforation de la structure organique 10, que les perforations peuvent prendre la forme de trous ou de stries, ou toute autre forme, l'essentiel étant que chaque perforation contribue à favoriser la diffusion du fluide 2 dans la structure organique 10 lors du traitement du dispositif multicouche 1 dans le réacteur.

Sur la figure 2, est illustré le paramètre e qui définit l'espacement entre deux perforations 100 premières voisines entre elles.

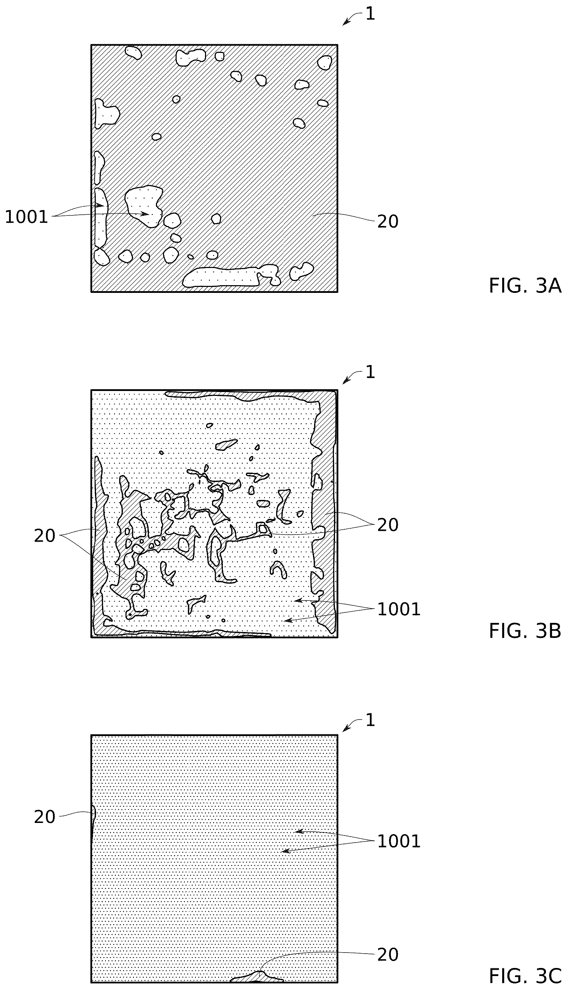

L'influence de cet espacement e a été étudiée, et les résultats obtenus sont illustrés sur les figures 3A à 3C. Plus particulièrement, des essais de délamination en milieu CO₂ SC ont été effectués sur des panneaux PV de 200 mm x 200 mm perforés et non perforés en utilisant la méthode de 2 pulses (130 bar pendant 30 minutes / 150 bar pendant 10 minutes) à une température de 75°C qui est décrite dans le document de brevet référencé FR308857 A1.

Les essais de délamination effectués sur les panneaux PV non perforés montrent que la diffusion du CO₂ est très limitée ; elle est principalement cantonnée aux bords du panneau PV. Les molécules de CO₂ pénètrent l'encapsulant 1022 jusqu'à une distance du bord comprise entre seulement 2 et 3 mm. Ce qui ne permet donc pas la délamination complète des panneaux PV avec la méthode de 2 pulses.

D'autres résultats de délamination ont été obtenus sur des panneaux PV perforés. Ces résultats illustrés sur les figures 3A, 3B et 3C ont été révélés à l'aide d'une caméra thermique. Cette dernière permet en effet de distinguer entre elles les zones sur lesquelles le dispositif multicouche a été délaminé des zones sur lesquelles le dispositif multicouche n'a pas été délaminé, suite à un traitement selon la méthode de 2 pulses. Les résultats illustrés sur les figures 3A, 3B et 3C montrent qu'un espacement e entre deux perforations de 10 mm (Figure 3A) a une efficacité de délamination de la face avant 11 en verre de 6,3%. Cette efficacité augmente à 86,3% avec des perforations espacées de 7 mm (Figure 3B) et atteint 99,3 % avec des perforations de 5 mm (Figure 3C).

Il ressort des résultats présentés ci-dessus que l'espacement e entre deux perforations 100 premières voisines entre elles est un autre paramètre d'importance du procédé selon l'invention, à l'instar de la profondeur des perforations 100. Et il est préférable que chaque perforation 100 se situe à une distance maximale e inférieure ou égale à 10 mm, préférentiellement inférieure ou égale à 7,5 mm, et encore plus préférentiellement inférieure ou égale à 5 mm, d'une autre perforation 100.

Un autre paramètre d'importance du procédé selon l'invention consiste en la taille caractéristique des perforations 100, i.e. le diamètre du trou 1001 ou la largeur d'ouverture de la strie 1002. Typiquement, ce paramètre doit être choisi de telle sorte que le fluide puisse pénétrer dans chaque perforation, de préférence avec aisance. Il peut donc dépendre de la nature du fluide, et plus particulièrement de la taille des molécules qui le constituent. Typiquement, une perforation présentant une taille caractéristique de l'ordre du millimètre, par exemple égale à 1 mm ou à 2 mm, permet d'atteindre une capacité de diffusion des fluides dans la perforation suffisante, voire très satisfaisante. Au regard de cette taille caractéristique des perforations, il est entendu que cette taille des perforations est de préférence inférieure à la distance maximale e susmentionnée.

L'effet du prétraitement selon la présente invention sur l'étape de traitement subséquente est essentiellement avantageux en termes de réduction du temps nécessaire à l'étape de traitement. En effet, la durée de l'étape de traitement peut dès lors être avantageusement limitée à 120 minutes, voire à 60 minutes, voire même à 45 minutes. À titre comparatif, sans perforations 100, le traitement pourrait durer plus de 10 jours, voire plus de 20 jours, pour un résultat potentiellement moins satisfaisant ; par exemple, pour un panneau PV de 2m² de surface, le temps estimé par calcul est de plus de 500 jours. Notons que le nombre de cycles de pressurisation et de dépressurisation n'est pas nécessairement limité à 2.

Plusieurs dispositifs, certains purement mécaniques, d'autres physiques, sont envisagés, qui sont propres à permettre de perforer la structure organique 10, le cas échéant en offrant un contrôle suffisant de la profondeur de perforation pour ne pas risquer de dégrader la plaque avant 11 en verre.

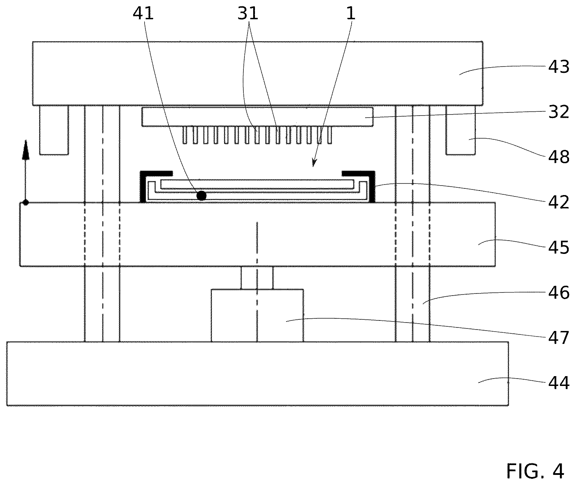

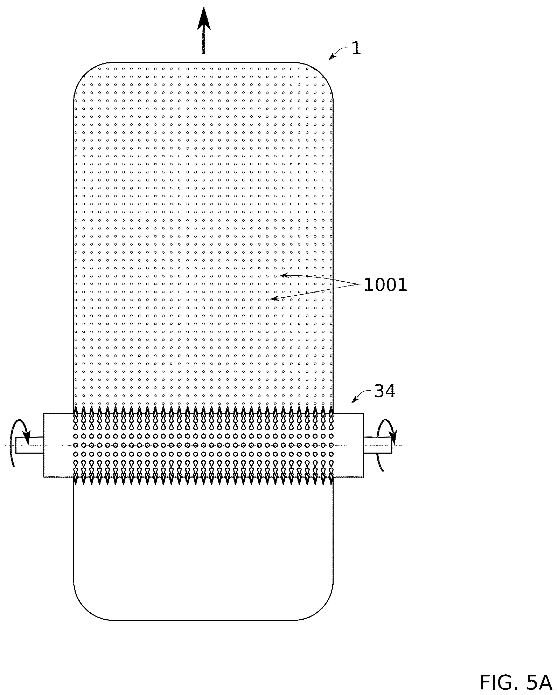

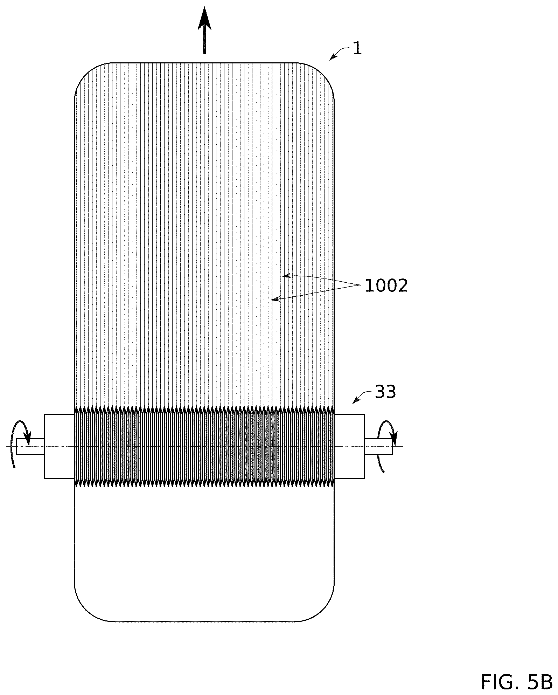

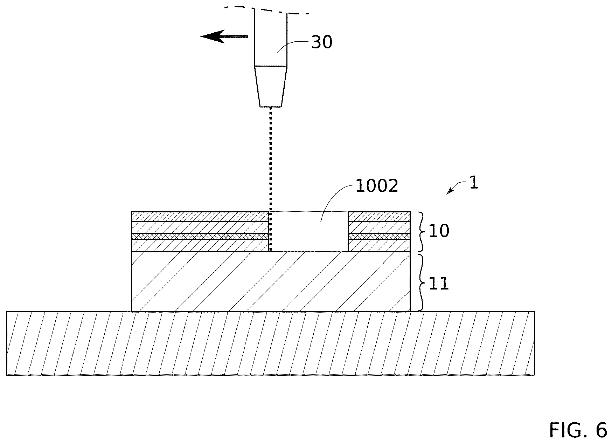

Quatre de ces dispositifs sont brièvement décrits ci-dessous en référence aux figures 4, 5A, 5B et 6. On notera que chacun des quatre dispositifs décrits sont de nature à être mis en œuvre industriellement.

Un premier dispositif de perforation, de type mécanique, est illustré sur la figure 4. Ce dispositif permet de perforer le panneau PV 1 à l'aide de pointes 31 métalliques d'un diamètre se situant entre 1 et 2 mm. Le panneau PV 1 est maintenu entre 2 plaques calibrées à cet effet. La plaque inférieure 41 ou plaque réceptacle est équipée d'un système anti-soulèvement 42 de sorte que le panneau PV 1, une fois perforé, ne reste pas empalé sur les pointes 31 s'étendant à la surface de la plaque 32 supérieure. Les pointes 31 ou aiguilles peuvent avoir été usinées dans la masse ou avoir été reportées sur la plaque 32. La composition chimique des pointes 31 peut être avantageusement choisie afin que celles-ci soient plus dures que la matière à perforer (en particulier, le silicium qui compose chaque cellule PV 1021 est susceptible d'être le matériau le plus dur à perforer parmi ceux qui composent la structure organique 10). Par exemple, lorsque l'on souhaite perforer du silicium sous forme métallique, la composition chimique des pointes 31 peut être avantageusement choisie de sorte que les pointes présentent une valeur supérieure ou égale à 6,5 mohs. Cela permet de limiter l'usure des pointes 31 et empêche la contamination de la matière du module PV 1 liée au dépôt métallique des pointes sur la matière perforée. Pour respecter ces critères, le matériau à base duquel les pointes sont constituées peut faire préférentiellement partie de la liste suivante : carbone diamant, carbure de bore (BC), carbure de silicium (SiC), alumine (Al₂O₃) ou carbure de tungstène (WC).

Plus particulièrement, le dispositif de perforation illustré sur la figure 4 met en œuvre trois platines 43, 44 et 45 équipées d'un système guidé mobile permettant une compression au niveau d'une plaque perforante (la plaque 32 équipée des pointes 31) et d'une plaque réceptacle 41 supportant le panneau PV 1. Le guidage de la platine mobile 45 s'effectue au moyen d'une colonne de guidage 46 permettant un alignement parfait entre les deux plaques. La platine mobile 45 ainsi guidée peut être articulée au moyen d'un vérin hydraulique 47 à simple effet. Une butée de réglage 48 peut en outre permettre de régler la profondeur de la perforation de la structure organique 10 du panneau PV 1, sans casser la face arrière 11 en verre, qui est en contact de la plaque réceptacle 41. Une plaque anti-soulèvement 42 permet de maintenir le panneau PV 1 perforé lors de la descente de la platine mobile 45.

Ce dispositif de perforation illustre une mise en œuvre relativement simple pour une perforation multiple à l'aide d'un objet perforant, mais ne doit être interprétée de façon limitative. Les pointes 31 pourraient par exemple être remplacées par des lames pour obtenir des stries 1002, plutôt que des trous 1001. Par ailleurs, un système de chauffe (non représenté) efficace et le cas échéant multizone des objets perforants (aiguilles, pointes, clous...) peut être mis en place pour faciliter la perforation de la structure organique 10. Le réglage de la température peut alors s'effectuer en fonction de la température de fusion des polymères à perforer en réduisant l'énergie mécanique nécessaire pour la perforation, voire en adaptant la température aux éventuelles variations de composition de la structure organique 10. Dans le cas d'encapsulant de cellules PV, les températures de fusion de l'encapsulant sont typiquement comprises entre 60 et 90 °C. Les températures adaptées à l'étape de traitement sont approximativement égales ou supérieures à la (plus haute) température de fusion impliquée à laquelle sensiblement 10°C sont ajoutés.

Dans une seconde version, le dispositif de perforation peut être configuré pour mettre en œuvre un ou plusieurs rouleaux à aiguilles 34 qui peuvent être chauffés ou non. Ce type de dispositif est par exemple rencontré, pour un tout autre objectif, dans la production d'emballage alimentaire ou dans l'industrie papetière. Il présente l'avantage de pouvoir être intégré dans un processus continu. La profondeur de pénétration des aiguilles est réglable en continu et permet de déterminer le diamètre du trou 1001.

Selon une troisième version, le dispositif de perforation peut être configuré pour mettre en œuvre un ou plusieurs rouleaux striés 33. De la même manière, la profondeur des stries 1002 est réglable en continu et permet de déterminer la largeur de la strie 1002 laissée dans la structure organique 10 du panneau PV 1. Il est possible de prévoir des rouleaux striés agencés dans un autre sens, par exemple perpendiculairement, que celui du rouleau illustré, notamment pour obtenir une découpe en carrés ou en losanges de la structure organique 10.

Un dispositif de perforation non mécanique est également envisagé qui met en œuvre un dispositif de découpe au laser 30. La découpe au laser peut en effet être utilisée comme méthode de perforation de la structure organique 10 pour favoriser la délamination des panneaux PV 1. Cette méthode de découpe est bien connue de l'homme de l'art et permet d'augmenter la productivité de manière significative. De plus, cette technologie est précise, ne déforme pas ou peu la matière et convient à la plupart des matériaux. Les lasers de haute puissance sont généralement utilisés, mais, dans notre cas, des lasers de puissance moyenne peuvent convenir permettant ainsi un gain d'énergie non négligeable.

Exemple : Mise en œuvre de l'étape de pré-traitement permettant de favoriser la pénétration de molécules de CO₂ dans un polymère d'encapsulation de type EVA

À titre d'exemples non limitatifs, ce type de polymères peut être utilisé pour l'encapsulation de modules OV 1, de diodes électroluminescentes ou OLED, de transistors de type TFT, de photodétecteurs par exemple de type organique. Le pré-traitement selon le procédé de l'invention permet de réduire le temps nécessaire à la délamination de la structure multicouche de polymère par CO₂ SC pulsé.

Selon la première étape, le pré-traitement du dispositif multicouche 1 consiste en la perforation mécanique ou physique des polymères constitutifs de la structure organique 10, afin d'augmenter la cinétique de diffusion du CO₂ SC mise en œuvre dans la seconde étape, i.e. l'étape de traitement. La profondeur des perforations, leur espacement, ainsi que leur géométrie, sont adaptés à l'épaisseur de la structure organique 10 et de la composition des matériaux en présence.

Selon la seconde étape, i.e. l'étape de traitement, des cycles d'absorption et de dépressurisation de CO₂ sont mis en œuvre pour délaminer la structure multicouche du dispositif multicouche 1. Dans l'exemple des panneaux PV 1, la méthode « pulsée » qu'il est conseillé de mettre en œuvre est décrite dans le brevet FR 3088579 A1. Elle consiste à réaliser plusieurs cycles successifs d'absorption (ou pressurisation) et de dépressurisation à différentes conditions opératoires. Le premier cycle effectué à 75°C, 130 bar et à une vitesse de dépressurisation de 2,7 bar.s⁻¹ permet de séparer la face arrière 101 et de réaliser le moussage de l'encapsulant 1022, en créant des voies de pénétration pour le CO₂. Le second cycle effectué à 150 bar permet de finaliser la séparation entre la face avant 11 en verre et l'encapsulant 1022 et d'ouvrir l'encapsulation des cellules PV 1021, pour permettre un traitement ultérieur, et en particulier la réutilisation de plaque 11 en verre.

L'invention n'est pas limitée aux modes de réalisations précédemment décrits et s'étend à tous les modes de réalisation couverts par les revendications.

## Revendications

1. Procédé de délamination d'un dispositif multicouche (1) comprenant au moins une structure organique (10), le procédé comprenant les étapes suivantes :
• Une étape de pré-traitement du dispositif multicouche (1) consistant à perforer (100) ladite au moins une structure organique (10) par endroits, puis
• Une étape de traitement, dans un réacteur, du dispositif multicouche (1) consistant à le soumettre à au moins un cycle de pressurisation et de dépressurisation d'un fluide (2).

2. Procédé selon la revendication précédente, dans lequel, le dispositif multicouche (1) comprenant en outre une face avant (11) en verre, la perforation (100) de ladite au moins une structure organique (10) est réalisée depuis une face arrière (12) du dispositif multicouche (1) qui est opposée à sa face avant (11).

3. Procédé selon l'une quelconque des revendications précédentes, dans lequel ladite au moins une structure organique (10) comprend une face arrière (101) à base d'au moins un polymère et une couche (102) comprenant au moins un transducteur (1021) et le cas échéant un encapsulant (1022) dudit au moins un transducteur (1021), l'encapsulant (1022) étant à base d'au moins un polymère.

4. Procédé de délamination selon l'une quelconque des revendications précédentes, dans lequel au moins une perforation (100), de préférence chaque perforation (100), est réalisée dans une épaisseur de ladite au moins une structure organique (10) du dispositif multicouche (1).

5. Procédé selon la revendication précédente, dans lequel au moins une perforation (100), de préférence chaque perforation (100), est réalisée dans toute l'épaisseur de ladite au moins une structure organique (10) du dispositif multicouche (1).

6. Procédé de délamination selon l'une quelconque des revendications précédentes, dans lequel au moins une perforation (100), de préférence chaque perforation (100), de ladite au moins une structure organique (10) se présente sous la forme d'un trou (1001) ou d'une strie (1002).

7. Procédé de délamination selon l'une quelconque des revendications précédentes, dans lequel chaque perforation (100) se situe à une distance maximale inférieure ou égale à 10 mm, préférentiellement inférieure ou égale à 7,5 mm, et encore plus préférentiellement inférieure ou égale à 5 mm, d'une autre perforation (100).

8. Procédé de délamination selon l'une quelconque des revendications précédentes, dans lequel l'étape de traitement a une durée inférieure à 120 minutes, préférentiellement inférieure à 60 minutes et encore plus préférentiellement inférieure à 45 minutes.

9. Procédé de délamination selon l'une quelconque des revendications précédentes, dans lequel le fluide (2) est choisi parmi :
• le dioxyde de carbone CO2 ;
• l'hexafluorure de soufre ;
• le protoxyde d'azote ;
• les alcanes linéaires ou ramifiés, tels que le méthane, les propanes, les butanes, et les pentanes ;
• les alcanes cycliques ;
• les alcènes linéaires ou ramifiés, tels que l'éthylène et le propylène ;
• les alcools, tels que le méthanol, l'éthanol, les propanols, et les butanols ; et
• leurs mélanges.

10. Procédé de délamination selon l'une quelconque des revendications précédentes, dans lequel chaque cycle de pressurisation et de dépressurisation comprend :
• une compression du fluide (2) en augmentant la pression dans le réacteur jusqu'à une pression P1, à laquelle le fluide se trouve dans un premier état physique; puis
• une décompression du fluide (2) en diminuant la pression dans le réacteur depuis la pression P1 jusqu'à une pression P2 à laquelle le fluide se trouve dans un deuxième état physique, la pression P2 étant inférieure à la pression P1.

11. Procédé selon la revendication précédente, dans lequel ledit au moins un cycle est précédé d'une mise en contact, dans le réacteur, du dispositif multicouche (1) avec le fluide (2) à une température T0, telle que la température ambiante, et une pression P0, telle que la pression atmosphérique.

12. Procédé de délamination selon l'une quelconque des revendications précédentes, exempt d'une étape de réduction de taille du dispositif multicouche (1), et en particulier exempt d'une étape de broyage ou de concassage du dispositif multicouche (1).

13. Procédé de délamination selon l'une quelconque des revendications précédentes, dans lequel au moins une perforation (100) est réalisée à l'aide d'un laser (30).

14. Procédé de délamination selon l'une quelconque des revendications précédentes, dans lequel une pluralité de perforations (100) est réalisée simultanément à l'aide d'une pluralité correspondante de pointes (31) s'étendant depuis une même face d'une plaque (32).

15. Procédé de délamination selon l'une quelconque des revendications précédentes, dans lequel une pluralité de perforations (100) est réalisée à l'aide d'un rouleau strié (33) ou à pointes (34).

## Patentansprüche

1. Delaminierungsverfahren einer mehrschichtigen Vorrichtung (1), die mindestens eine organische Struktur (10) umfasst, wobei das Verfahren die folgenden Schritte umfasst:
• einen Vorbehandlungsschritt der mehrschichtigen Vorrichtung (1), der darin besteht, die mindestens eine organische Struktur (10) stellenweise zu perforieren (100), dann
• einen Behandlungsschritt der mehrschichtigen Vorrichtung (1) in einem Reaktor, der darin besteht, sie mindestens einem Druckbeaufschlagungs- und Druckabfallzyklus eines Fluids (2) zu unterziehen.

2. Verfahren nach dem vorstehenden Anspruch, wobei die mehrschichtige Vorrichtung (1) außerdem eine vordere Fläche (11) aus Glas umfasst, wobei die Perforation (100) der mindestens einen organischen Struktur (10) ausgehend von einer hinteren Fläche (12) der mehrschichtigen Vorrichtung (1), die der vorderen Fläche (11) entgegengesetzt ist, durchgeführt wird.

3. Verfahren nach einem der vorstehenden Ansprüche, wobei die mindestens eine organische Struktur (10) eine hintere Fläche (101) auf der Grundlage mindestens eines Polymers und eine Schicht (102) umfasst, die mindestens einen Transducer (1021) und gegebenenfalls ein Kapselungsmittel (1022) des mindestens einen Transducers (1021) umfasst, wobei das Kapselungsmittel (1022) auf der Grundlage von mindestens einem Polymer ist.

4. Delaminierungsverfahren nach einem der vorstehenden Ansprüche, wobei mindestens eine Perforation (100), bevorzugt jede Perforation (100), in einer Dicke der mindestens einen organischen Struktur (10) der mehrschichtigen Vorrichtung (1) hergestellt wird.

5. Verfahren nach dem vorstehenden Anspruch, wobei mindestens eine Perforation (100), bevorzugt jede Perforation (100), in einer Dicke der mindestens einen organischen Struktur (10) der mehrschichtigen Vorrichtung (1) hergestellt wird.

6. Delaminierungsverfahren nach einem der vorstehenden Ansprüche, wobei mindestens eine Perforation (100), bevorzugt jede Perforation (100), der mindestens einen organischen Struktur (10) die Form eines Lochs (1001) oder einer Riffel (1002) aufweist.

7. Delaminierungsverfahren nach einem der vorstehenden Ansprüche, wobei jede Perforation (100) in einem maximalen Abstand kleiner oder gleich 10 mm, bevorzugt kleiner oder gleich 7,5 mm und besonders bevorzugt kleiner oder gleich 5 mm von einer anderen Perforation (100) liegt.

8. Delaminierungsverfahren nach einem der vorstehenden Ansprüche, wobei der Behandlungsschritt eine Dauer von weniger als 120 Minuten, bevorzugt weniger als 60 Minuten und besonders bevorzugt weniger als 45 Minuten aufweist.

9. Delaminierungsverfahren nach einem der vorstehenden Ansprüche, wobei das Fluid (2) ausgewählt wird aus:
• Kohlenstoffdioxid CO2;
• Schwefelhexafluorid;
• Stickstoffoxid;
• linearen oder verzweigten Alkanen, wie Methan, Propanen, Butanen und Pentanen;
• zyklischen Alkanen;
• linearen oder verzweigten Alkanen, wie Ethylen oder Propylen;
• Alkoholen, wie Methanol, Ethanol, Propanolen und Butanolen; und
• ihren Mischungen.

10. Delaminierungsverfahren nach einem der vorstehenden Ansprüche, wobei jeder Druckbeaufschlagungs- und Druckabfallzyklus Folgendes umfasst:
• eine Kompression des Fluids (2), indem der Druck in dem Reaktor bis zu einem Druck P1 erhöht wird, bei dem sich das Fluid in einem ersten physischen Zustand befindet; dann
• einen Druckabfall des Fluids (2), indem der Druck in dem Reaktor von dem Druck P1 bis auf einen Druck P2 verringert wird, bei dem sich das Fluid in einem zweiten physischen Zustand befindet, wobei der Druck P2 geringer ist als der Druck P1.

11. Verfahren nach dem vorstehenden Anspruch, wobei dem mindestens einen Zyklus ein Inkontaktbringen in dem Reaktor der mehrschichtigen Vorrichtung (1) mit dem Fluid (2) bei einer Temperatur T0, wie der Umgebungstemperatur, und einem Druck P0, wie dem Luftdruck, vorausgeht.

12. Delaminierungsverfahren nach einem der vorstehenden Ansprüche, ohne einen Größenverringerungsschritt der mehrschichtigen Vorrichtung (1) und insbesondere ohne einen Zerkleinerungs- oder Mahlschritt der mehrschichtigen Vorrichtung (1).

13. Delaminierungsverfahren nach einem der vorstehenden Ansprüche, wobei mindestens eine Perforation (100) mit Hilfe eines Lasers (30) hergestellt wird.

14. Delaminierungsverfahren nach einem der vorstehenden Ansprüche, wobei eine Vielzahl von Perforationen (100) gleichzeitig mit Hilfe einer Vielzahl entsprechender Spitzen (31), die sich von derselben Fläche einer Platte (32) erstrecken, hergestellt wird.

15. Delaminierungsverfahren nach einem der vorstehenden Ansprüche, wobei eine Vielzahl von Perforationen (100) mit Hilfe einer Walze mit Riffeln (33) oder Spitzen (34) hergestellt wird.

## Claims

1. Method for delaminating a multilayer device (1) comprising at least one organic structure (10), the method comprising the following steps:
- A step of pre-treating the multilayer device (1) consisting of perforating (100) said at least one organic structure (10) in places, then
- A step of treating, in a reactor, the multilayer device (1) consisting of subjecting it to at least one cycle of pressurising and depressurising a fluid (2).

2. Method according to the preceding claim, wherein, the multilayer device (1) further comprising a glass front face (11), the perforation (100) of said at least one organic structure (10) is made from a rear face (12) of the multilayer device (1) which is opposite its front face (11).

3. Method according to any one of the preceding claims, wherein said at least one organic structure (10) comprises a rear face (101) with the basis of at least one polymer and a layer (102) comprising at least one transducer (1021) and, if necessary, an encapsulant (1022) of said at least one transducer (1021), the encapsulant (1022) being with the basis of at least one polymer.

4. Delamination method according to any one of the preceding claims, wherein at least one perforation (100), preferably each perforation (100), is made in a thickness of said at least one organic structure (10) of the multilayer device (1).

5. Method according to the preceding claim, wherein at least one perforation (100), preferably each perforation (100), is made in the entire thickness of said at least one organic structure (10) of the multilayer device (1).

6. Delamination method according to any one of the preceding claims, wherein at least one perforation (100), preferably each perforation (100), of said at least one organic structure (10) is presented in the form of a hole (1001) or a ridge (1002).

7. Delamination method according to any one of the preceding claims, wherein each perforation (100) is located at a maximum distance less than or equal to 10mm, preferably less than or equal to 7.5mm, and even more preferably less than or equal to 5mm, of another perforation (100).

8. Delamination method according to any one of the preceding claims, wherein the treatment step has a duration less than 120 minutes, preferably less than 60 minutes, and even more preferably less than 45 minutes.

9. Delamination method according to any one of the preceding claims, wherein the fluid (2) is chosen from among:
- carbon dioxide CO₂;
- sulphur hexafluoride;
- nitrogen protoxide;
- linear or branched alkanes, such as methane, propanes, butanes, and pentanes;
- cyclic alkanes;
- linear or branched alkenes, such as ethylene and propylene;
- alcohols, such as methanol, ethanol, propanols, butanols; and
- their mixtures.

10. Delamination method according to any one of the preceding claims, wherein each pressurising and depressurising cycle comprises:
- a compression of the fluid (2) by increasing the pressure in the reactor up to a pressure P1, at which the fluid is located in a first physical state; then
- a decompression of the fluid (2) by decreasing the pressure in the reactor from the pressure P1 up to a pressure P2, at which the fluid is located in a second physical state, the pressure P2 being less than the pressure P1.

11. Method according to the preceding claim, wherein said at least one cycle is preceded by a contacting, in the reactor, of the multilayer device (1) with the fluid (2) at a temperature T0, such as ambient temperature, and a pressure P0, such as atmospheric pressure.

12. Delamination method according to any one of the preceding claims, with no step of reducing the size of the multilayer device (1), and in particular, with no step of grinding or crushing the multilayer device (1).

13. Delamination method according to any one of the preceding claims, wherein at least one perforation (100) is made using a laser (30).

14. Delamination method according to any one of the preceding claims, wherein a plurality of perforations (100) is made simultaneously using a corresponding plurality of spikes (31) extending from one same face of a plate (32).

15. Delamination method according to any one of the preceding claims, wherein a plurality of perforations (100) is made using a ridged (33) or spike (34) roller.
